# EUROPEAN PATENT SPECIFICATION

(11) **EP 1 026 799 B1**
(45) Date of publication and mention of the grant of the patent: **10.04.2002**
(21) Application number: 00101635.1
(22) Date of filing: 31.01.2000
(51) Int. Cl.: H01S 5/323, H01L 33/00

(54) **Semiconductor laser and fabricating method therefor**
Halbleiterlaser und zugehöriges Herstellungsverfahren
Laser à semi-conducteur et son procédé de fabrication

(30) Priority: 01.02.1999 JP 2380599
(43) Date of publication of application: 09.08.2000
(73) Proprietor: Pioneer Corporation, Meguro-ku, Tokyo (JP)
(72) Inventor: Kumura, Yoshinori, Tsurugashima-shi, Saitama 350-2288 (JP); Ota, Hiroyuki, Tsurugashima-shi, Saitama 350-2288 (JP); Nishitsuka, Mitsuru, Tsurugashima-shi, Saitama 350-2288 (JP)
(74) Representative: Klingseisen, Franz, Dipl.-Ing.

(56) References cited:
- EP-A- 0 851 542
- PATENT ABSTRACTS OF JAPAN vol. 1999, no. 04, 30 April 1999 (1999-04-30) -& JP 11 017277 A (SHARP CORP), 22 January 1999 (1999-01-22)

## Description

### BACKGROUND OF THE INVENTION

### 1. Field of the Invention

The present invention relates to a semiconductor laser with a structure which restricts a lateral transverse mode and the fabricating method therefor.

### 2. Description of Related Art

Among semiconductor lasers for use in optical disk systems or the like, there are available semiconductor lasers called "index-guided lasers". The kind of semiconductor lasers comprises a waveguide that parallels to the direction along which an optical cavity is formed, and allows laser beams to be confined within said waveguide to obtain desired optical output while maintaining a stable lateral transverse mode.

A semiconductor laser has a configuration that consists of various semiconductor layers, stacked on a substrate, such as an active layer, cladding layers and guide layers.

One type of the index-guided lasers is fabricated by a method comprising the steps of forming a groove portion on a semiconductor layer, and stacking layers thereafter in sequence such as a cladding layer and the like. The groove structure must be fabricated by means of dry etching in the case of insoluble semiconductors which cannot be "etched" by wet etchant, such as GaN and related materials. However, it is a problem that the crystalline quality of an active layer is deteriorated by the damage layer of a groove portion, which is fabricated by dry etching.

### OBJECT AND SUMMARY OF THE INVENTION

Accordingly, an object of the present invention is to provide a semiconductor laser that has a good crystalline quality and capability of lasing in a stable fundamental transverse mode, and the fabricating method therefor.

A method for fabricating a semiconductor laser according to the present invention, the method fabricating a GaN-based semiconductor laser, is characterized by comprising the steps of forming a first mask on a first conductive layer composed of an n-type semiconductor the width of said first mask being selected to be a value between 2 and 10 micrometers, depositing a second conductive layer of a thickness not exceeding the thickness of said first mask, removing said first mask, depositing an n-type cladding layer of a thickness not exceeding the thickness of said first mask, depositing optical waveguide layers including at least an active layer, and depositing a p-type cladding layer. Claim 10 defines a laser device obtainable by the above method.

### BRIEF DESCRIPTION OF THE DRAWINGS

Fig. 1 is a cross-sectional view showing and example of a structure of a conventional semiconductor laser.

Fig. 2 is a cross-sectional view showing and example of a structure of a semiconductor laser according to the present invention.

Fig. 3 is a cross-sectional view showing the structure with a SiO₂ mask formed according to the fabricating method of the present invention.

Fig. 4 is a cross-sectional view showing the structure with a re-grown GaN layer formed according to the fabricating method of the present invention.

Fig. 5 is a cross-sectional view showing the structure with a SiO₂ mask removed according to the fabricating method of the present invention.

Fig. 6 is a cross-sectional view showing the structure with a p-type GaN contact layer formed according to the fabricating method of the present invention.

### DETAILED DESCRIPTION OF THE EMBODIMENTS

Before beginning an explanation of the embodiments of the present invention, an example of a conventional semiconductor laser is explained with reference to the drawings.

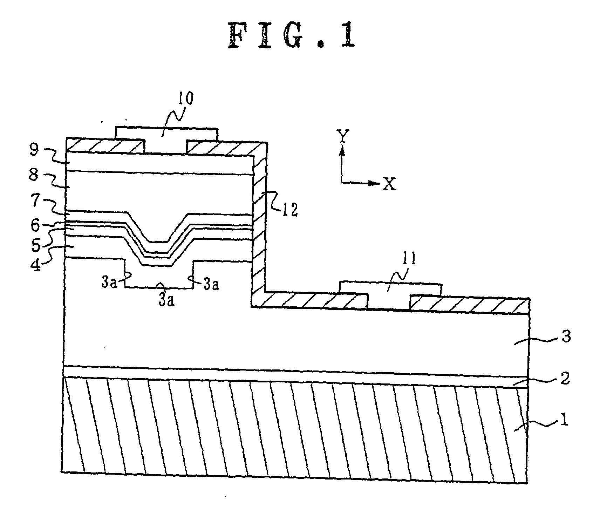

Fig. 1 shows an example of a conventional semiconductor laser. As is evident from Fig. 1, the semiconductor laser is formed in the shape of a stripe that extends in the direction parallel to the direction (perpendicular to the paper surface) along which an optical cavity is formed. The semiconductor laser has optical waveguide layers comprising an active layer and a guide layer which are bent to form steps in the direction of Y. That is, a low-temperature buffer layer 2 and an n-type semiconductor layer 3 having groove portions 3a are stacked on a substrate 1. In addition, an n-type cladding layer 4 which is bent along the groove portions 3a, an n-type guide layer 5, an active layer 6, a p-type guide layer 7, a p-type cladding layer 8, and a p-type contact layer 9 are stacked thereon in that order. Furthermore, a p-side electrode 10 and an n-side electrode 11 are stacked on the p-type contact layer 9 and the n-type semiconductor layer 3, respectively. The other surfaces of the p-type contact layer 9 and the n-type semiconductor layer 3 are covered with an insulating layer 12.

In cross section X-Y, the light generated in the active layer 6 is confined in the vertical direction by the optical waveguide layers comprising the n-type guide layer 5 and the p-type guide layer 7. In addition, part of the boundary between the p-type guide layer 7 and the p-type cladding layer 8 is located below the boundary between the n-type cladding layer 4 and the n-type guide layer 5. In this configuration, viewing in the direction of X, a refractive index step is formed across the optical waveguide layers with the n-type cladding layer 4, the optical waveguide layers, and the n-type cladding layer 4, adjacent to each other in that order. This structure allows a lateral transverse mode to be confined in this refractive index step.

Conventionally, the method for fabricating the semiconductor laser device of such a configuration used dry etching such as a reactive ion etching (RIE) or wet etching. This was a method which allows the groove processing of the groove portions 3a of the n-type semiconductor layer 3 to be performed from the top of the semiconductor layer formed flat. Moreover, from the top thereof, the method employed sequential stacking of the n-type cladding layer 4 and the other layers.

However, the groove processing on the n-type semiconductor layer 3 performed by means of dry etching such as RIE would cause the surface layer of the groove portions 3a to deteriorate in the crystalline quality and thus cause the so-called process damaged layer. Therefore, as mentioned in the foregoing, such a problem was presented in that depositing the cladding layer 4 thereon by means of the epitaxial growth could not produce a good crystalline quality and would cause the lasing characteristics of the obtained semiconductor laser to deteriorate. In particular, this was a serious problem for the GaN-based semiconductor laser that cannot employ wet etching instead of dry etching, which does not exert the process damage on the processed layer.

The embodiments of the present invention will be explained in detail with reference to the drawings.

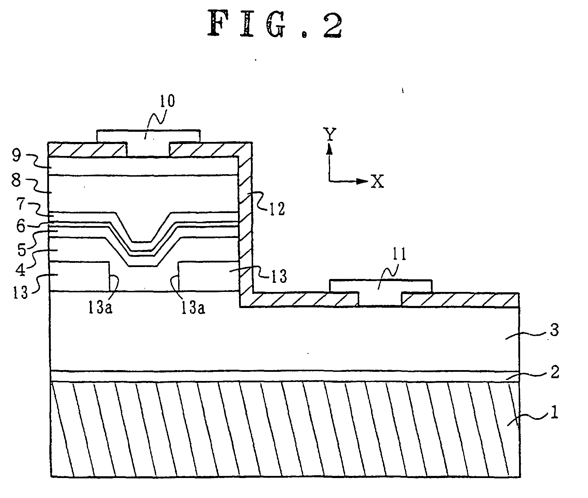

As shown in Fig. 2, the semiconductor laser according to the present invention comprises a multi-layer structure in which nitride semiconductor single crystalline layers, represented by (AlₓGa₁₋ₓ) _{1-y}In_{y}N (0 ≤ x ≤ 1, 0 ≤ y ≤ 1), are stacked in sequence on the substrate 1 composed of sapphire. On the substrate 1 composed of sapphire, the low-temperature buffer layer 2 composed of AlN, GaN, or the like, and the n-type GaN layer 3 into which Si is doped which composes the conductive layer are disposed in parallel to the substrate. On the n-type GaN layer 3, two stripe-shaped GaN re-grown layers 13 extend in the direction parallel to the direction (perpendicular to the paper surface) along which the optical cavity is formed. There are interstitial portions 13a having a width of 2 to 10µm in between the two GaN re-grown layers 13. The GaN re-grown layers 13 may be an n-type GaN into which Si or the like is doped or a p-type GaN into which Mg or the like is doped.

Along the shape of the interstitial portions 13a, the n-type cladding layer 4, the n-type guide layer 5, and the active layer 6 are disposed. Furthermore, the p-type guide layer 7, the p-type cladding layer 8, and the p-type contact layer 9 are disposed in that order. Suppose that the boundary between the n-type cladding layer 4 and the n-type guide layer 5 is a first boundary, and the boundary between the p-type guide layer 7 and the p-type cladding layer 8 is a. second boundary. Then, the second boundary of the bent portion is located below the first boundary excluding the bent portion.

Furthermore, the p-side electrode 10 and the n-side electrode 11 are disposed on the p-type contact layer 9 and the n-type GaN layer 3, respectively, and thus, constitute a semiconductor laser.

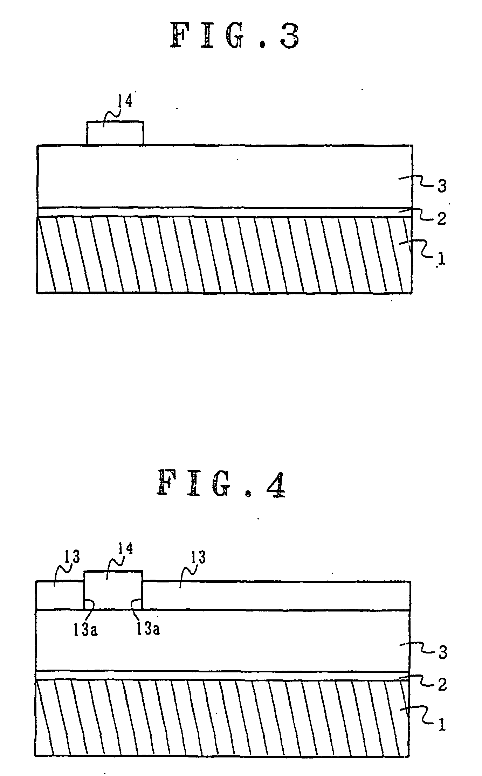

The method for fabricating a semiconductor laser, according to the present invention, will be described in detail with reference to Fig. 3 through Fig. 6.

As shown in Fig. 3, the sapphire substrate 1 is loaded into a metal organic chemical vapor deposition (MOCVD) furnace (not shown), and then the AlN or GaN buffer layer 2 is deposited on surface a or surface c of the sapphire at a low temperature. The deposition is performed by means of the metal organic chemical vapor deposition (MOCVD) method. After that, the n-type GaN layer 3 into which Si or the like has been doped is stacked by approximately 4µm by means of the MOCVD method to fabricate a base substrate. In the present invention, the MOCVD method is employed as the deposition method unless otherwise specified. The base substrate is taken out of the MOCVD deposition furnace and then a SiO₂ layer is deposited on the top by the sputtering method. The SiO₂ layer is deposited such that the thickness thereof is thicker than the optical waveguide layers comprising the active layer 6 and the guide layers 5 and 7 as described later. The layer is deposited also to have enough thickness to allow steps to be formed on part of the optical waveguide layers. For example, where the active layer is 0.1µm in thickness, and the p- and n-type guide layers are 0.1µm in thickness, respectively (that is, the optical waveguide layers are 0.3µm in thickness), the layer requires a thickness of 0.3µm or more. Furthermore, the stacked SiO₂ layer is patterned into the shape of a stripe by the photolithography method to form a SiO₂ mask 14. A a wet etching using hydrofluoric acid or a dry etching may be employed as the patterning process. It is preferable for the crystal growth of the GaN re-grown layers 13 which is to be described later that the stripe is oriented to <11-20> of the n-type GaN layer. In addition, the stripe serves to form the interstitial portions 13a formed between the GaN re-grown layers 13, as described below, thereby the width of the stripe define the width of the bent portions of the optical waveguide layers. The bent portions is an optical waveguide for confining the lateral transverse mode. Therefore, the width may be preferably 2 to 10µm.

As shown in Fig. 4, the substrate is loaded again to the MOCVD deposition furnace and the surface of the substrated is cleaned in an ammonia flow at a temperature of 1050°C. After that, the GaN re-grown layers 13 are deposited on the n-type GaN layer 3 partially covered with the SiO₂ mask 14. The GaN re-grown layers 13 are grown selectively on portions where the SiO₂ mask 14 is not present, and must not be deposited to greatly exceed the thickness of the SiO₂ mask 14 so as not to hang over the SiO₂ mask 14. In this step, the GaN re-grown layers 13 may be doped with Si or with Mg.

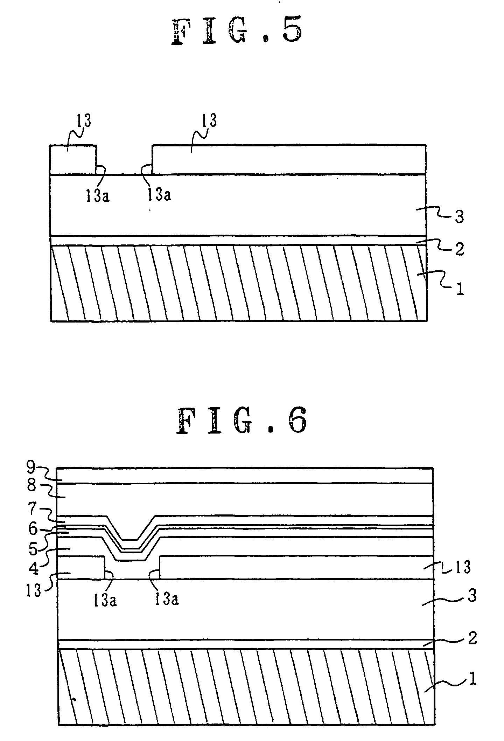

As shown in Fig. 5, the substrate is taken out of the furnace to remove the SiO₂ mask 14 using hydrofluoric acid, which leads to a configuration having the p-type GaN re-grown layers 13 with the interstitial portions 13a. If the aforementioned GaN re-grown layers 13 are doped with Mg, a semiconductor laser device thus obtained allows current to selectively flow through the interstitial portions 13a. There is thus created a PN junction between the n-type cladding layer 4 and the p-type GaN re-grown layers 13. Accordingly, providing a higher potential for the side of the n-type cladding layer 4 will cause the PN junction to be biased backward. This will not allow current to flow through the GaN re-grown layers 13, thereby enabling fabrication of a narrow structure of current into the interstitial portions 13a. This enables providing preferably an improved light-emitting characteristic of the laser device.

As shown in Fig. 6, the substrate is loaded again into the MOCVD deposition furnace and the surface of the substrate is cleaned in an ammonia air current at a temperature of 1050°C. After that, the n-type AlGaN cladding layer 4, the n-type GaN guide layer 5, and the active layer 6 are deposited in sequence. Furthermore, the p-type GaN guide layer 7, and the p-type AlGaN cladding layer 8, and the p-type GaN contact layer 9 are stacked.

Thereafter, a layer into which Mg has been doped is activated to perform annealing to turn it into a p-type layer. Then, ridges are formed by means of RIE or the like to allow the n-type GaN layer 3 to be exposed, and the SiO₂ insulating layer 12 layer is formed on other layers to provide windows for partially forming electrodes. A semiconductor laser is obtained by the p-side electrode 10 and the n-side electrode 11 on the p-type contact layer 9 and the n-type GaN layer 3 via the windows, respectively.

The present invention allows for forming the optical waveguide layers that are bent as described in the foregoing, while maintaining a good crystalline quality. Thus, the present invention provides stable characteristics of the lateral transverse mode without accompanying deterioration in the lasing characteristics such as an increase in the threshold current caused by the damage of the crystalline structure of the semiconductor laser obtained.

## Claims

1. A method for fabricating a GaN-based semiconductor laser comprising the steps of:
forming a first mask (14) on a first conductive layer (3) composed of an n-type semiconductor, the width of said first mask being selected to be a value between 2 and 10 micrometers, depositing a second conductive layer (13) of a thickness not exceeding the thickness of said first mask,
removing said first mask (14),
depositing an n-type cladding layer (4) of a thickness not exceeding the thickness of said first mask,
depositing optical waveguide layers (5, 6, 7) including at least an active layer (6), and
depositing a p-type cladding layer (8).

2. The method for fabricating a semiconductor laser according to Claim 1, wherein the step of forming said optical waveguide layers further comprises the steps of:
depositing an n-type guide layer (5), depositing an active layer (6), and
depositing a p-type guide layer (7).

3. The method for fabricating a semiconductor laser according to Claim 2, wherein the thickness of said second conductive layer (13) is thicker than that of said optical waveguide layers (3, 6, 7)

4. The method for fabricating a semiconductor laser according to Claim 3, wherein the step of forming said first mask (14) further comprises the steps of:
depositing a mask layer on said first conductive layer (3) and a second stripe-shaped mask on said mask layer,
removing said mask layer excluding the portions with which said second mask is covered, and
removing said second mask.

5. The method for fabricating a semiconductor laser according to Claims 1, 2, 3 or 4, wherein said first mask (14) is formed in parallel to a direction <11-20> of said first conductive layer (3).

6. The method for fabricating a semiconductor laser according to Claims 1, 2, 4 or 5, wherein said first mask (14) is composed of silicon dioxide.

7. The method for fabricating a semiconductor laser according to Claims 1, 2 or 6, wherein said second conductive layer (13) is composed of a p-type semiconductor.

8. The method for fabricating a semiconductor laser according to Claims 1, 2, 5, 6 or 7, wherein the step of forming said first mask (14) further comprises the steps of:
depositing a mask layer on said first conductive layer and a second stripe-shaped mask on said mask layer,
removing said mask layer excluding the portions with which said second mask is covered, and
removing said second mask.

9. The method for fabricating a semiconductor laser according to Claims 5 or 8, wherein the thickness of said second conductive layer (13) is thicker than that of said optical waveguide layers (5, 6, 7).

10. A GaN-based semiconductor laser obtainable by the fabrication method of Claims 1, 2, 5, 6 or 7, including at least on a conductive layer a multi-layer structure wherein an n-type cladding layer (4), optical waveguide layers (5, 6, 7) including at least an active layer (6), and a p-type cladding layer (8) are stacked in that order,
wherein a part of said optical waveguide layers (5, 6, 7) comprises a bent portion which forms stripe-shaped steps which extend in parallel to a direction along which an optical cavity is formed,
said conductive layer comprises said first conductive layer (3) and said second conductive layer (13) on top thereof,
said first conductive layer (3) is composed of an n-type semiconductor, and
said second conductive layer (13) comprises two stripe-shaped bodies which extend in parallel to a direction along which an optical cavity is formed, said bent portion is positioned between said stripe shaped bodies, **characterised in that** inner faces of said stripe shaped bodies are directed to be substantially perpendicular to said first conductive layer.

11. The semiconductor laser according to Claim 10, wherein the upper boundary of said optical waveguide layers (5, 6, 7) in said bent portion is located further below the lower boundary of said optical waveguide layers excluding said bent portion.

## Patentansprüche

1. Verfahren zum Herstellen eines auf GaN basierenden Halbleiterlasers, aufweisend die Schritte:
Bilden einer ersten Maske (14) auf einer ersten leitenden Schicht (3), die aus einem Halbleiter vom N-Typ besteht, wobei die Breite der ersten Maske mit einem Wert zwischen 2 und 10 Mikrometer gewählt ist,
Abscheiden einer zweiten leitenden Schicht: (13) mit einer Dicke, die die Dicke der ersten Maske nicht übersteigt,
Entfernen der ersten Maske (14),
Abscheiden einer Hüllenschicht (4) vom N-Typ mit einer Dicke, die die Dicke der ersten Maske nicht übersteigt, Abscheiden optischer Wellenleiterschichten (5, 6, 7), die zumindest eine aktive Schicht (6) umfassen, und
Abscheiden einer Hüllenschicht (8) vom P-Typ.

2. Verfahren zum Herstellen eines Halbleiterlasers nach Anspruch 1, wobei der Schritt zum Bilden der optischen Wellenleiterschichten zusätzlich die Schritte aufweist:
Abscheiden einer Leitschicht (5) vom N-Typ,
Abscheiden einer aktiven Schicht (6), und
Abscheiden einer Leitschicht (7) vom P-Typ.

3. Verfahren zum Herstellen eines Halbleiterlasers nach Anspruch 2, wobei die Dicke der zweiten leitenden Schicht (13) dicker ist als diejenige der optischen Wellenleiterschichten (5, 6, 7).

4. Verfahren zum Herstellen eines Halbleiterlasers nach Anspruch 3, wobei der Schritt zum Bilden der ersten Maske (14) außerdem die Schritte aufweist:
Abscheiden einer Maskenschicht auf der ersten leitenden Schicht (3) und einer zweiten streifenförmigen Maske auf der Maskenschicht,
Entfernen der Maskenschicht mit Ausnahme derjenigen Abschnitte, mit denen die zweite Maske abgedeckt ist, und
Entfernen der zweiten Maske.

5. Verfahren zum Herstellen eines Halbleiterlasers nach Anspruch 1, 2, 3 oder 4, wobei die erste Maske (14) parallel zu einer Richtung <11-20> der ersten leitenden Schicht 3 gebildet ist.

6. Verfahren zum Herstellen eines Halbleiterlasers nach Anspruch 1, 2, 4 oder 5, wobei die erste Maske (14) aus Siliziumdioxid besteht.

7. Verfahren zum Herstellen eines Halbleiterlasers nach Anspruch 1, 2 oder 6, wobei die zweite leitende Schicht (13) aus einem Halbleiter vom P-Typ besteht.

8. Verfahren zum Herstellen eines Halbleiterlasers nach Anspruch 1, 2, 5,6 oder 7, wobei der Schritt zum Bilden der ersten Maske (14) außerdem die Schritte aufweist:
Abscheiden einer Maskenschicht auf der ersten leitenden Schicht und einer zweiten streifenförmigen Maske auf der Maskenschicht;
Entfernen der Maskenschicht mit Ausnahme derjenigen Abschnitte, mit denen die zweite Maske abgedeckt ist, und
Entfernen der zweiten Maske.

9. Verfahren zum Herstellen eines Halbleiterlasers nach Anspruch 5 oder 8, wobei die Dicke der zweiten leitenden Schicht (13) dicker als diejenige der optischen Wellenleiterschichten (5, 6, 7) ist.

10. Auf GaN basierender Halbleiterlaser, der durch das Herstellungsverfahren der Ansprüche 1, 2, 5, 6 oder 7 gewinnbar ist, aufweisend zumindest eine leitende Schicht mit Mehrschichtstruktur, wobei eine Hüllenschicht (4) vom N-Typ, optische Wellenleiterschichten (5, 6, 7), enthaltend zumindest eine aktive Schicht (6), und eine Hüllenschicht (8) vom P-Typ in dieser Abfolge übereinander angeordnet sind,
wobei ein Teil der optischen Wellenleiterschichten (5, 6, 7) einen gebogenen Abschnitt umfasst, der streifenförmige Stufen bildet, die sich parallel zu einer Richtung erstrecken, entlang welcher ein optischer Hohlraum gebildet ist,
wobei die leitende Schicht die erste leitende Schicht (3) und die zweite leitende Schicht (13) auf ihrer Oberseite umfasst,
wobei die erste leitende Schicht (3) aus einem Halbleiter vom N-Typ besteht, und
wobei die zweite leitende Schicht (13) zwei streifenförmige Körper umfasst, die sich parallel zu einer Richtung erstrecken, entlang derer ein optischer Hohlraum gebildet ist, wobei der gebogene Abschnitt zwischen den streifenförmigen Körpern zu liegen kommt, **dadurch gekennzeichnet, dass** die Innenseiten der streifenförmigen Körper so gerichtet sind, dass sie im Wesentlichen senkrecht zu der ersten leitenden Schicht verlaufen.

11. Halbleiterlaser nach Anspruch 10, wobei die obere Grenze der optischen Wellenleiterschichten (5, 6, 7) ein gebogener Abschnitt ist, der weiter unter der unteren Grenze der optischen Wellenleiterschichten angeordnet ist, mit Ausnahme des gebogenen Abschnitts.

## Revendications

1. Procédé de fabrication d'un laser à semiconducteurs à base de GaN comprenant les étapes consistant à :
former un premier masque (14) sur une première couche conductrice (3) constituée par un semiconducteur de type n, la largeur dudit premier masque étant choisie égale à une valeur comprise entre 2 et 10 micromètres,
déposer une seconde couche conductrice (13) ayant une épaisseur ne dépassant pas l'épaisseur dudit premier masque,
retirer ledit premier masque (14),
déposer une couche de revêtement de type n (4) ayant une épaisseur ne dépassant pas l'épaisseur dudit premier masque,
déposer des couches formant guides d'ondes optiques (5,6,7) comprenant au moins une couche active (6), et
déposer une couche de revêtement (8) de type p.

2. Procédé pour fabriquer un laser à semiconducteurs selon la revendication 1, dans lequel l'étape de formation desdits couches de guides d'ondes optiques comprend en outre les étapes consistant à :
déposer une couche de guidage (5) de type n,
déposer une couche active (6), et
déposer une couche de guidage (7) de type p.

3. Procédé pour fabriquer un laser à semiconducteurs selon la revendication 2, selon lequel l'épaisseur de ladite seconde couche conductrice (13) est inférieure à celle desdites couches formant guides d'ondes optiques (3,6,7).

4. Procédé pour fabriquer un laser à semiconducteurs selon la revendication 3, selon lequel l'étape de formation dudit premier masque (14) comprend en outre les étapes consistant à :
déposer une couche formant masque sur ladite première couche conductrice (3) et un second masque en forme de bande sur ladite couche formant masque,
retirer ladite couche formant masque à l'exclusion des parties par lesquelles ledit second masque est recouvert, et
retirer ledit second masque.

5. Procédé pour fabriquer un laser à semiconducteurs selon la revendication 1, 2, 3 ou 4, selon lequel ledit premier masque (14) est déformé parallèlement à une direction <11-20> de ladite première couche conductrice (3).

6. Procédé pour fabriquer un laser à semiconducteurs selon la revendication 1, 2, 4 ou 5, dans lequel ledit premier masque (14) est constitué de bioxyde de silicium.

7. Procédé pour fabriquer un laser à semiconducteurs selon la revendication 1, 2 ou 6, selon lequel ladite seconde couche conductrice (13) est formée d'un semiconducteur de type p.

8. Procédé pour fabriquer un laser à semiconducteurs selon la revendication 1, 2, 5, 6 ou 7, selon lequel l'étape de formation dudit premier masque (14) comprend en outre les étapes consistant à :
déposer une couche formant masque sur ladite première couche conductrice et un second masque en forme de bande sur ladite couche formant masque,
retirer ladite couche formant masque à l'exclusion des parties avec lesquelles le disque formant masque est recouvert, et
retirer ledit second masque.

9. Procédé pour fabriquer un laser à semiconducteurs selon la revendication 5 ou 8, selon lequel l'épaisseur de ladite seconde couche conductrice (13) est inférieure à celle desdites couches formant guides d'ondes optiques (3,6,7).

10. Laser semiconducteur à base de GaN pouvant être obtenu à l'aide du procédé de fabrication selon la revendication 1, 2, 5, 6 ou 7, incluant au moins, sur une couche conductrice, une structure à couches multiples, dans laquelle une couche de revêtement (4) du type n, des couches formant guides d'ondes optiques (5,6,7) incluant au moins une couche active (6), et une couche de revêtement (8) de type p sont empilées dans cet ordre,
dans lequel une partie desdites couches formant guides d'ondes optiques (5,6,7) comprend une partie coudée qui forme les parties étagées en forme de bandes qui s'étendent parallèlement à une direction le long de laquelle une cavité optique est formée,
ladite couche conductrice comprend ladite première couche conductrice (3) et ladite seconde couche conductrice (13), à sa partie supérieure,
ladite première couche conductrice (3) est constituée d'un semiconducteur de type n, et
ladite seconde couche conductrice (13) comprend deux corps en forme de bandes qui s'étendent parallèlement dans une direction le long de laquelle est formée une cavité optique, ladite partie coudée étant positionnée entre lesdits corps en forme de bandes,
**caractérisé en ce que** des faces intérieures desdits corps en forme de bandes sont orientées de manière à être sensiblement perpendiculaires à ladite première couche conductrice.

11. Laser à semiconducteurs selon la revendication 10, dans lequel la limite supérieure desdits couches formant guides optiques (5,6,7) dans ladite partie coudée est située plus au-dessous de la limite inférieure desdites couches formant guides d'ondes optiques, à l'exclusion de ladite partie coudée.
